# EUROPEAN PATENT APPLICATION

(11) **EP 4 589 991 A1**
(43) Date of publication of application: **23.07.2025**
(21) Application number: 24218336.6
(22) Date of filing: 09.12.2024
(51) Int. Cl.: H04R 5/02, H04R 1/02, H04R 1/26, H04R 1/28

(54) **SOUND DEVICE AND DISPLAY DEVICE INCLUDING THE SAME**

(30) Priority: 16.01.2024 KR 20240006439
(71) Applicant: LG Electronics Inc., Yeongdeungpo-gu Seoul 07336 (KR)
(72) Inventor: YOUN, Hyunseung, 06772 Seoul (KR)
(74) Representative: Schornack, Oliver

(57) **Abstract**

Disclosed is a sound device. The sound device may include a frame, a first speaker adjacent to the frame, a second speaker spaced apart from the first speaker, a first holder located between the frame and the first speaker and coupled to the frame and the first speaker, and a second holder located between the frame and the second speaker and coupled to the frame and the second speaker, wherein the second speaker may have the same shape as the first speaker inverted 180 degrees.

## Description

### CROSS-REFERENCE TO RELATED APPLICATION

This application claims priority to Korean Patent Application No. 10-2024-0006439, filed in the Republic of Korea on January 16, 2024, the entire contents of which is hereby expressly incorporated by reference into the present application.

### BACKGROUND OF THE INVENTION

### Field of the invention

The present disclosure relates to a sound device and a display device including the same.

### Description of the Related Art

As the information society develops, the demand for display devices is increasing in various forms, and in response to this, recently, various display devices, such as liquid crystal displays (LCDs), plasma display panels (PDPs), electro luminescent displays (ELDs), vacuum fluorescent displays (VFDs), organic light emitting diodes (OLEDs), and the like, are being researched and used.

Thereamong, an LCD panel has a TFT substrate and a color substrate which face each other with a liquid crystal layer interposed therebetween, and may display images using light provided from a backlight unit. Further, an OLED panel may display images through an organic material layer capable of emitting light on its own deposited on a substrate on which a transparent electrode is formed.

These display devices are equipped with a speaker. Here, the speaker is a device which converts electroacoustic signals into sound waves and outputs the same. Speakers may be subdivided into woofers, mid-range speakers, tweeters, full-range speakers, and the like depending on the sound range.

In keeping with the recent trend of slimming display devices, the thickness of speakers provided in display devices is also becoming thinner.

### SUMMARY OF THE INVENTION

An object of the present disclosure is to solve the above problems and other problems.

Another object of the present disclosure may be to provide a structure which couples a speaker to a frame.

Another object of the present disclosure may be to provide a structure which couples a first speaker and a second speaker provided in the shape of the inverted first speaker to a frame.

Another object of the present disclosure may be to provide a structure for implementing symmetry between sound from a first speaker and sound from a second speaker.

Another object of the present disclosure may be to provide a structure which improves the sense of stereo separation between a first speaker and a second speaker.

Another object of the present disclosure may be to provide a structure which minimizes the length of cables connecting a first speaker and a second speaker to an amplifier.

Another object of the present disclosure may be to provide a structure which expands an outlet of a speaker unit with respect to a stand of a display device which covers a speaker hole.

In accordance with an aspect of the present disclosure for achieving the above and other objects, a sound device may include a frame, a first speaker adjacent to the frame, a second speaker spaced apart from the first speaker, a first holder located between the frame and the first speaker and coupled to the frame and the first speaker, and a second holder located between the frame and the second speaker and coupled to the frame and the second speaker, wherein the second speaker may have the same shape as the first speaker inverted 180 degrees.

### BRIEF DESCRIPTION OF THE DRAWINGS

The above and other objects, features and other advantages of the present disclosure will be more clearly understood from the following detailed description taken in conjunction with the accompanying drawings, in which:

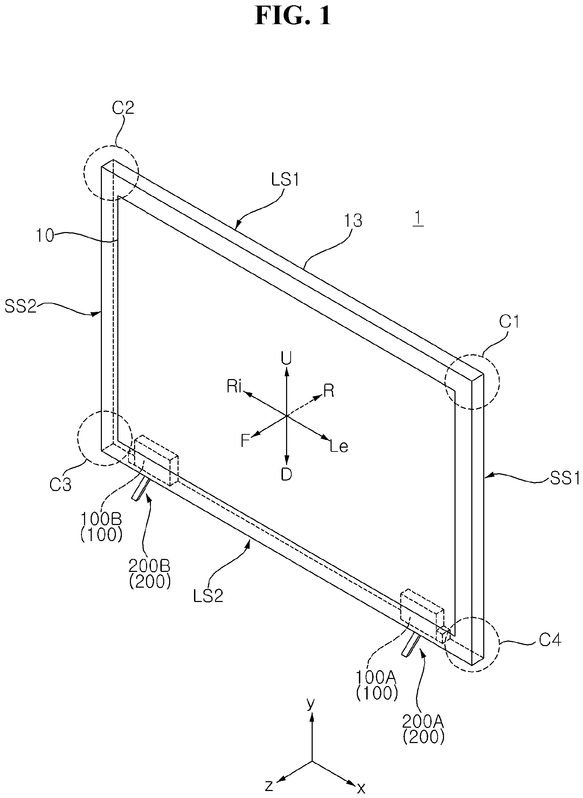

FIGs. 1 to 21 are views illustrating examples of sound devices and display devices having the same according to embodiments of the present disclosure.

### DETAILED DESCRIPTION

Hereinafter, embodiments of the present disclosure will be described in detail with reference to the accompanying drawings. The same or similar elements are denoted by the same reference numerals even though they are depicted in different drawings, and a redundant description thereof will be omitted.

The suffixes "module" and "part" for elements used in the following description are given or used interchangeably only for ease of preparing the description, and do not have distinct meanings or roles in themselves.

In the following description of the embodiments of the present disclosure, a detailed description of known functions and configurations incorporated herein will be omitted when it may make the subject matter of the present disclosure rather unclear. In addition, it will be understood that the accompanying drawings are only for easy understanding of the embodiments of the present disclosure, the technical idea disclosed in the present disclosure is not limited by the accompanying drawings, and the embodiments of the present disclosure are provided only to completely disclose the disclosure and cover modifications, equivalents or alternatives which come within the scope and technical range of the disclosure.

In the following description of the embodiments, terms, such as "first" and "second", are used only to describe various elements, and these elements should not be construed as being limited by these terms. These terms are used only to distinguish one element from other elements.

When an element or layer is referred to as being "connected to" or "coupled to" another element or layer, it may be directly connected or coupled to the other element or layer, or intervening elements or layers may be present. In contrast, when an element or layer is referred to as being "directly connected to" or "directly coupled to" another element or layer, there may be no intervening elements or layers present. Other words used to describe relationships between elements should be interpreted in a like fashion, e.g., "between" versus "directly between," "adjacent" versus "directly adjacent," etc.

Singular expressions include plural expressions as well, unless the context clearly indicates otherwise.

The terms "comprises," "comprising," "including," and "having" are inclusive and therefore specify the presence of stated features, integers, operations, operations, elements, components, and/or combinations thereof, but do not preclude the presence or addition of one or more other features, integers, operations, operations, elements, components, and/or combinations thereof.

The direction indications of up U, down D, left Le, right Ri, front F, and rear R shown in the drawings are only for convenience of explanation, and the technical idea disclosed in the present disclosure is not limited thereby.

Hereinafter, a display panel of the present disclosure may be an OLED panel, which will be described below with reference to FIG. 2, or an LCD panel, which will be described below with reference to FIGs. 3 and 4, but the present disclosure may be applied to various types of display panels other than the OLED panel and the LCD panel.

Referring to FIG. 1, a display device 1 may include a display panel 10. The display panel 10 may display images.

The display device 1 may include a first long side LS1, a second long side LS2 opposite the first long side LS1, a first short side SS1 adjacent to the first long side LS1 and the second long side LS2, and a second short side SS2 opposite the first short side SS 1. Although, for convenience of explanation, the length of the first and second long sides LS 1 and LS2 is shown and described as being longer than the length of the first and second short sides SS1 and SS2, the length of the first and second long sides LS1 and LS2 may be approximately the same as the length of the first and second short sides SS1 and SS2.

A direction parallel to the long sides LS1 and LS2 of the display device 1 may be referred to as the leftward and rightward directions. A direction parallel to the short sides SS1 and SS2 of the display device 1 may be referred to as the upward and downward directions. A direction perpendicular to the long sides LS1 and LS2 and the short sides SS1 and SS2 of the display device 1 may be referred to as the forward and rearward directions.

A direction in which display panel 10 displays images may be referred to as forward F based on the z-axis, and the opposite direction may be referred to as rearward R. A direction of the first long side LS1 may be referred to as upward U based on the y-axis, and a direction of the second long side LS2 may be referred to as downward D. A direction of the first short side SS1 may be referred to as leftward Le based on the z-axis, and a direction of the second short side SS2 may be referred to as rightward Ri.

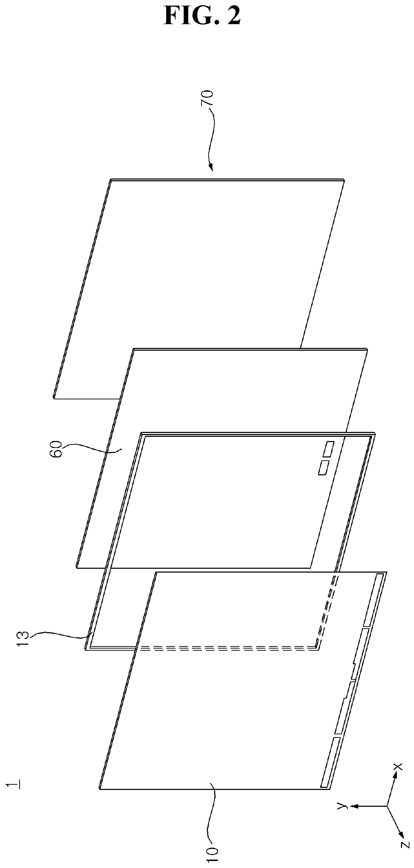

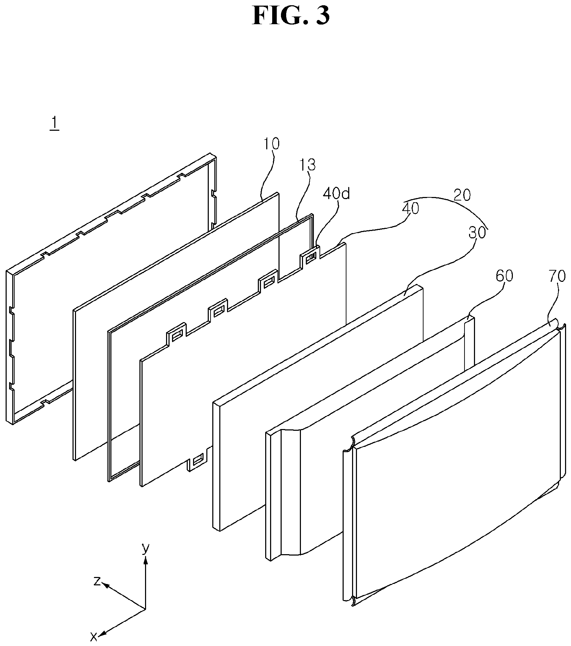

The first long side LS1, the second long side LS2, the first short side SS1, and the second short side SS2 may be referred to as edges of the display device 1. A side frame 13, which will be described later (see FIGs. 2 and 3), may define the edges of the display device 1. Points where the first long side LS1, the second long side LS2, the first short side SS1, and the second short side SS2 meet each other may be referred to as corners.

For example, a point where the first short side SS1 and a first long side LS1 meet may be referred to as a first corner C1. A point where the first long side LS1 and the second short side SS2 meet may be referred to as a second corner C2. A point where the second short side SS2 and the second long side LS2 meet may be referred to as a third corner C3. A point where the second long side LS2 and the first short side SS2 meet may be referred to as a fourth corner C4.

Referring to FIG. 2, the display device 1 may include the display panel 10, the side frame 13, a frame 60, and a back cover 70.

The display panel 10 may define the front surface of the display device 1, and may display images. The display panel 10 may divide an image into a plurality of pixels, and may output the image with color, brightness, and saturation for each pixel. The display panel 10 may be divided into an active area where images are displayed, and an in-active area where images are not displayed. The display panel 10 may generate light of red, green, or blue depending on a control signal. The display panel 10 may be referred to as an OLED panel.

The side frame 13 may extend along the edge of the display panel 10. The side frame 13 may be referred to as a guide panel 13 or a middle cabinet 13.

The frame 60 may be located behind the display panel 10, and may be coupled to the display panel 10. The side frame 13 may be located between the display panel 10 and the frame 60, and may be coupled to the display panel 10 and the frame 60. Electronic components may be mounted on the frame 60. For example, the frame 60 may include a metal material, such as aluminum alloy. The frame 60 may be referred to as a main frame 60, a module cover 60, or a bottom cover 60.

The back cover 70 may cover the rear part of the frame 60. The back cover 70 may be coupled to the frame 60. As an example, the back cover 70 may be an injection molded product formed of a resin. As another example, the back cover 70 may include a metal material.

Referring to FIG. 3, the display device 1 may include a display panel 10, a side frame 13, a backlight unit 20, a frame 60, and a back cover 70.

The display panel 10 may define the front surface of the display device 1, and may display images. The display panel 10 may display an image as each pixel of a plurality of pixels outputs red, green or blue (RGB) light according to timing. The display panel 10 may be divided into an active area where images are displayed, and an in-active area where images are not displayed. The display panel 10 may include a front substrate and a rear substrate which face each other with a liquid crystal layer interposed therebetween. The display panel 10 may be referred to as an LCD panel.

The front substrate may include the plurality of pixels including red, green, and blue subpixels. The front substrate may output light corresponding to red, green, or blue, depending on a control signal.

The rear substrate may include switching elements. The rear substrate may switch pixel electrodes. For example, the pixel electrode may change the molecular arrangement of the liquid crystal layer depending on a control signal input from the outside. The liquid crystal layer may include liquid crystal molecules. The arrangement of the liquid crystal molecules may be changed in response to a voltage difference generated between the pixel electrode and a common electrode. The liquid crystal layer may transmit light provided from the backlight unit 20 to the front substrate, or may block the light.

The side frame 13 may extend along the edge of the display panel 10. The side frame 13 may be referred to as a middle cabinet 13.

The backlight unit 20 may be located behind the display panel 10. The backlight unit 20 may include light sources. The backlight unit 20 may be coupled to the front surface of the frame 60. The backlight unit 20 may be driven in a full driving method or a partial driving method, such as local dimming or impulsive driving. The backlight unit 20 may include an optical sheet 40 and an optical layer 30.

The optical sheet 40 may uniformly transmit light from the light sources to the display panel 10. The optical sheet 40 may include a plurality of layers. For example, the optical sheet 40 may include a prism sheet, a diffusion sheet, or the like.

The frame 60 may be located behind the display panel 10, and may be coupled to the display panel 10. The side frame 13 may be located between the display panel 10 and the frame 60, and may be coupled to the display panel 10 and the frame 60. Electronic components may be mounted on the frame 60. For example, the frame 60 may include a metal material, such as aluminum alloy. The frame 60 may be referred to as a main frame 60, a module cover 60, or a bottom cover 60.

The back cover 70 may cover the rear part of the frame 60. The back cover 70 may be coupled to the frame 60. As an example, the back cover 70 may be an injection molded product formed of a resin. As another example, the back cover may include a metal material.

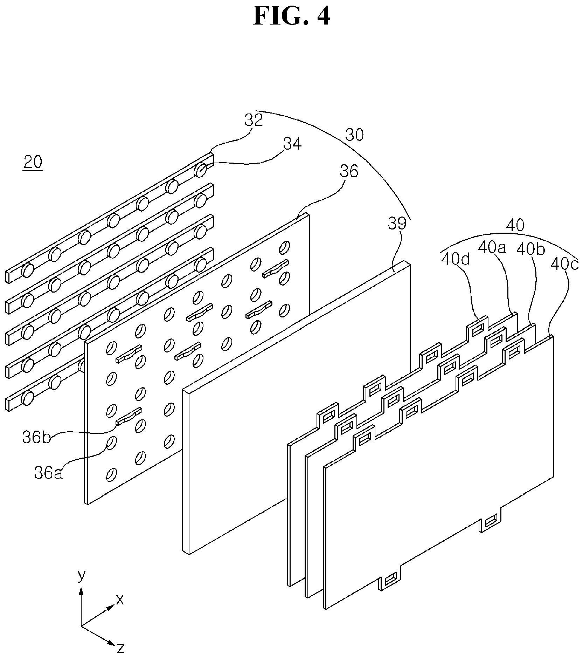

Referring to FIGs. 3 and 4, the backlight unit 20 may include the optical layer 30 and the optical sheet 40. The optical layer 30 may include a substrate 32, at least one light source 34, a reflective sheet 36, and a diffusion plate 39.

The substrate 32 may be coupled to the front surface of the frame 60. The substrate 32 may have a plate shape, or may include a plurality of straps spaced apart from each other in the vertical direction. The substrate 32 may be formed of at least one of polyethylene terephthalate (PET), glass, polycarbonate (PC), or silicon. The substrate 32 may be a printed circuit board (PCB).

The at least one light source 34 may be mounted on the substrate 32. A plurality of light sources 34 may be spaced apart from each other on the substrate 32. An electrode pattern configured to connect the light sources 34 to an adapter to may be formed on the substrate 32. For example, a carbon nanotube electrode pattern configured to connect the light sources 34 to the adapter may be formed on the substrate 32.

For example, the light source 34 may be a light emitting diode (LED) chip or a light emitting diode package including at least one LED chip. The light source 34 may be a colored LED which emits light of at least one color of red, green, blue, or the like, or a white LED. The colored LED may include at least one of a red LED, a green LED, or a blue LED. The light source 34 may be referred to as a light assembly 34.

The reflective sheet 36 may be located in front of the substrate 32. The reflective sheet 36 may be located an area of the substrate 32 excluding areas where the light sources 34 are formed. The reflective sheet 36 may have a hole 36a in which the light sources 34 are located.

Further, the reflective sheet 36 may include at least one of a metal or a metal oxide as a reflective material. For example, the reflective sheet 36 may include a metal and/or a metal oxide having high reflectivity, such as at least one of aluminum (Al), silver (Ag), gold (Au), or titanium dioxide (TiO2). For example, a resin may be deposited or applied to the light sources 34 and/or the reflective sheet 36. The resin may diffuse light from the light sources 34. Accordingly, the reflective sheet 36 may reflect light from the light sources 34 or light reflected by the diffusion plate 39 forward.

The diffusion plate 39 may be located in front of the reflective sheet 36. The diffusion plate 39 may diffuse light from the light sources 34. Spacers 36b may be located between the reflective sheet 36 and the diffusion plate 39, and may support the rear surface of the diffusion plate 39. Accordingly, an air gap may be formed between the reflective sheet 36 and the diffusion plate 39, and light from the light sources 34 may be spread widely by the air gap.

The optical sheet 40 may be located in front of the diffusion plate 39. The rear surface of the optical sheet 40 may be in close contact with the diffusion plate 39, and the front surface of the optical sheet 40 may be in close contact with or adjacent to the rear surface of the display panel 10. The optical sheet 40 may include a diffusion sheet and/or a prism sheet.

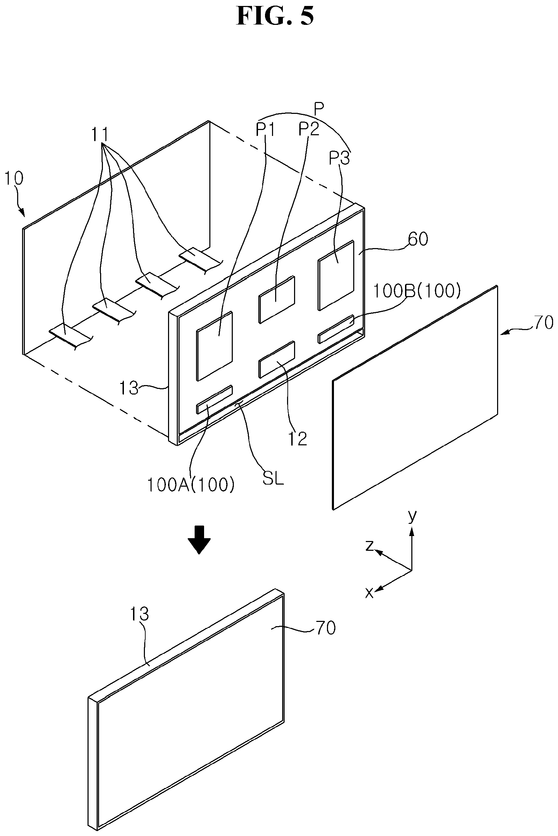

Referring to FIG. 5, boards P may be coupled to the frame 60. The boards P may be located between the frame 60 and the back cover 70, and may be coupled to the rear surface of the frame 60. A plurality of electronic devices may be mounted on the boards P. The boards P may be printed circuit boards, and may be electrically connected to electronic components of the display device.

A power supply board P1 may supply power to the respective components of the display device. A main board P3 may control the respective components of the display device. A timing controller board P2 may be connected to the main board P3 through a cable 11, and may provide an image signal to the display panel 10.

Cables 11 may be electrically connected to the display panel 10 adjacent to the lower side of the display panel 10. The cables 11 may pass through a slit SL or a hole formed in the frame 60. A source PCB 12 may be electrically connected to the rear surface of the frame 60 adjacent to the lower side of the frame 60, and may be electrically connected to the cables 11. The source PCB 12 may be electrically connected to the timing controller board P2 through the cable 11.

Accordingly, the timing controller board P2 may provide digital video data and a timing control signal to the display panel 10 through the source PCB 12.

Speakers 100 may be coupled to the frame 60. The speakers 100 may be located between the frame 60 and the back cover 70, and may be coupled to the rear surface of the frame 60. The speakers 100 may be adjacent to one side of the frame 60. The speakers 100 may be adjacent to the lower side of the frame 60, and may provide sound to the front lower part of the display device 1. For example, a plurality of speakers 100A and 100B may be coupled to the frame 60.

A sound device may include the speakers 100, a frame 60, components (holders described later) which couple the speakers 100 to the frame 60. The frame 60 may be the frame 60 of the above-described display device. Alternatively, the frame 60 may be a frame of an audio device.

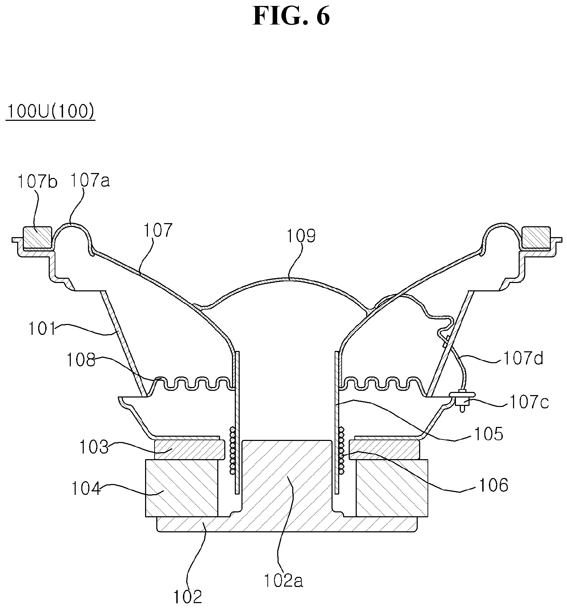

Referring to FIG. 6, a speaker frame 101 may support components of a speaker unit 100U of the speaker 100. The speaker frame 101 may be installed in a speaker box 101H of the speaker 100, which will be described later. The speaker 100 may be referred to as a speaker assembly 100 or a speaker module 100.

A first plate 102 may form one side of the speaker unit 100U. A pole piece 102a may protrude from the central portion of the first plate 102, and may have the shape of a hollow cylinder or a solid cylinder. A second plate 103 may be spaced apart from the first plate 102, and may have a ring shape. A portion of the pole piece 102a may penetrate the second plate 103, and an air gap may be formed between the second plate 103 and the pole piece 102a.

A magnet 104 may be disposed between the first plate 102 and the second plate 103, and may have a ring shape. A portion of the pole piece 102a may pass through the magnet 104. A bobbin 105 may be located in the air gap between the pole piece 102a and the second plate 103 and an air gap between the pole piece 102a and the magnet 104, and may have the shape of a hollow cylinder extending in the length direction of the pole piece 102a. A coil 106 may be formed or wound on the outer circumferential surface of the bobbin 105, and may be referred to as a voice coil. A terminal 107c and a tinsel wire 107d may transmit electrical energy output from an amplifier to the coil 106.

A spider 108 may have elasticity. The spider 108 may be located between the bobbin 105 and the speaker frame 101, and may be coupled to the bobbin 105 and the speaker frame 101. The spider 108 may support the bobbin 105, and may be referred to as a damper 108.

One side of a diaphragm 107 may be coupled or attached to the bobbin 105, and the other side of the diaphragm 107 may be supported by an edge 107a having elasticity. For example, the diaphragm 107 may have a cone or dome shape. A gasket 107b may be provided on the side surface of the edge 107a, and may prevent interference of the vibrating diaphragm 107 with surrounding devices. For example, a dust cap 109 may cover the central portion of the diaphragm 107, and may prevent dust or the like from flowing into a magnetic circuit.

When lines of magnetic force are generated in the air gap by the magnet 104 and current flows along the coil 106, Lorentz force may be generated. The magnitude of the Lorentz force may be proportional to the size of the lines of magnetic force (a magnetic flux density), the amount of current, and the length of the wound coil 106, and the direction of the Lorentz force may be at a right angle to a plane formed by the magnetic flux density and current.

Accordingly, the diaphragm 107 may vibrate in the length direction of the pole piece 102a. Based on FIG. 6, when the diaphragm 107 moves upward, positive (+) sound pressure may be generated, when the diaphragm 107 moves downward, negative (-) sound pressure may be generated, and the speaker unit 100U may provide sound upward. Depending on such vibration of the diaphragm 107, air in the speaker box 101H may also resonate, and the pressure in the speaker box 101H may be changed.

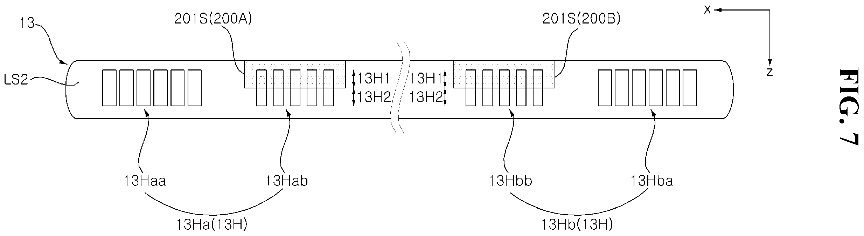

Referring to FIG. 7, a hole 13H may be formed in the side frame 13 adjacent to the speakers 100 (see FIG. 5). For example, the speakers 100 may be adjacent to the second long side LS2, i.e., the lower side of the display device 1, and the hole 13H may be formed in a portion of the side frame 13 which defines the second long side LS2. Sound output from the speakers 100 may be provided to the outside through the hole 13H. The hole 13H may be formed as holes spaced apart from each other. A plurality of holes 13H may face a plurality of speakers 100.

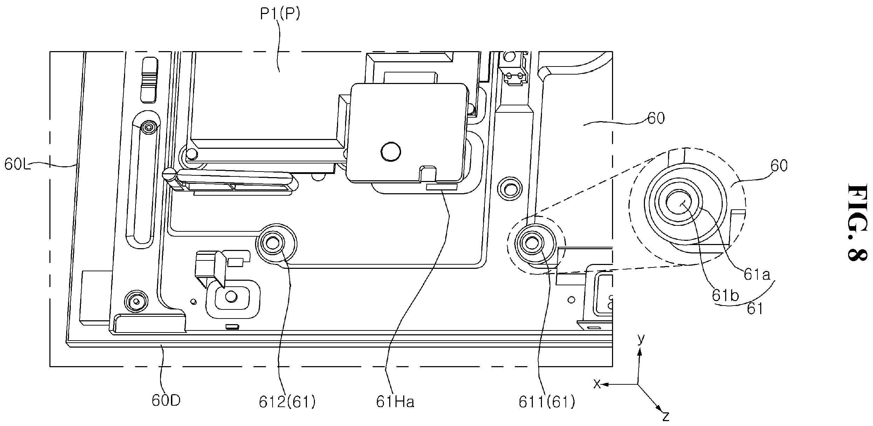

Referring to FIG. 8, fixing parts 61 may be formed by pressing the frame 60 from the front to the rear. The fixing parts 61 may be referred to as forming parts 61. A fixing hole 61b may be formed to penetrate the fixing part 61. For example, a plurality of fixing parts 611 and 612 may be spaced apart from each other.

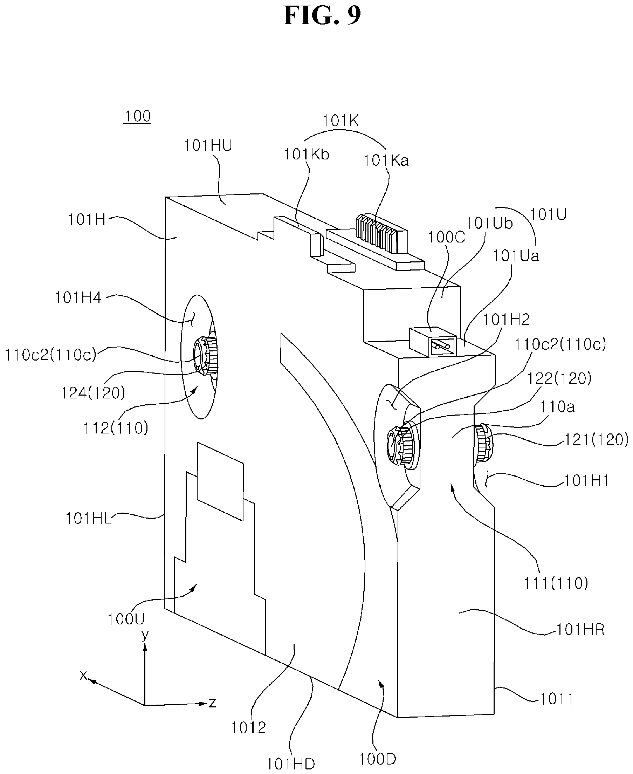

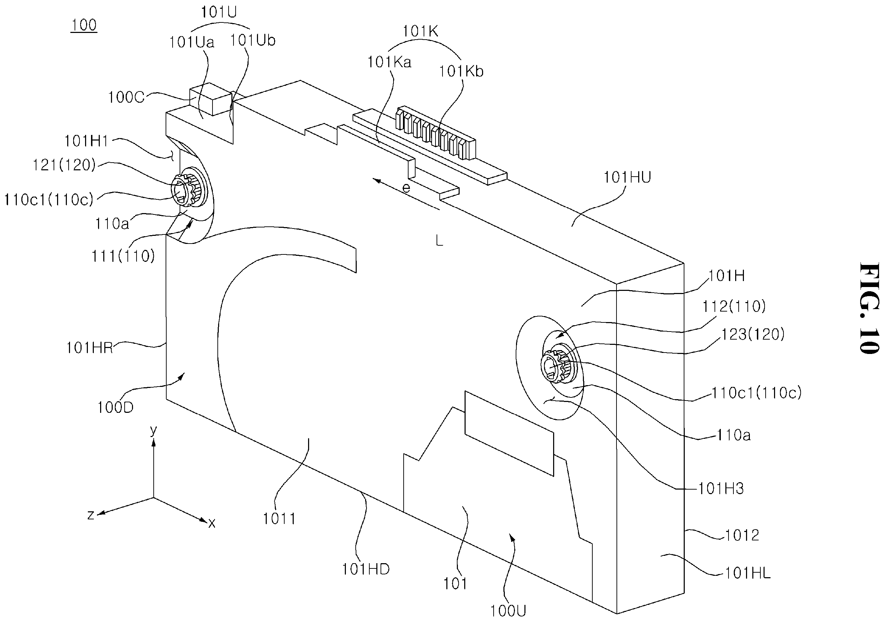

Referring to FIGs. 9 and 10, the components of the speaker unit 100U descried above with reference to FIG. 6 may be mounted in and on the speaker box 101H of the speaker 100. The diaphragm 107 (see FIG. 6) of the speaker unit 100U may provide sound to the bottom of the speaker box 101H. The speaker box 101H may be referred to as an enclosure 101H, a housing 101H, or a case 101H.

The speakers 100 may be adjacent to a lower side 60D (see FIG. 8) of the frame 60. A first speaker 100A may be adjacent to a left side 60L of the frame 60, and a second speaker 100B may be adjacent to a right side 60R of the frame (see FIG. 1). Coupling parts 110 may be formed on one side of the speaker box 101H, and may be coupled to the fixing parts 61 (see FIG. 8) through holders 120. For example, a plurality of coupling parts 111 and 112 may be spaced apart from each other, and may be coupled to a plurality of fixing parts 611 and 612 (see FIG. 8) through a plurality of holders 121, 122, 123, and 124. Accordingly, the speakers 100 may be mounted on the rear part of the frame 60.

Hooks 101K may protrude from one side of the speaker box 101H. A first hook 101Ka and a second hook 101Kb may protrude from the upper side of the speaker box 101H, and may be spaced apart from each other in the thickness direction of the speaker box 101H. As an example, the first hook 101Ka and the second hook 101Kb may face each other, and may be spaced apart from a vertical line L passing through the center of the speaker box 101H by a designated distance. As another example, the first hook 101Ka and the second hook 101Kb may be disposed alternately.

A first insertion hole 61Ha may be formed in the frame 60 adjacent to the left side 60L of the frame 60, and the first hook 101Ka may be hooked to the first insertion hole 61Ha.

A second insertion hole (not shown) may be formed in the frame 60 adjacent to the right side 60R of the frame 60, and the second hook 101Kb may be hooked to the second insertion hole.

Here, as the first and second hooks 101Ka and 101Kb are arranged eccentrically from the vertical line passing through the center of the speaker box 101H or alternately, incorrect insertion of the first and second hooks 101Ka and 101Kb into the first and second insertion holes 60Ha may be prevented.

Meanwhile, the hooks 101K may be omitted, and in this case, the speakers 100 may be mounted on the frame 60 only through the holders 120.

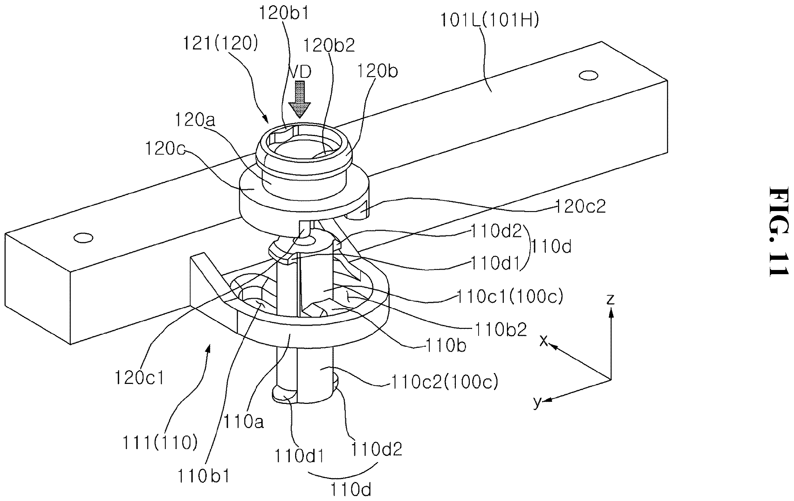

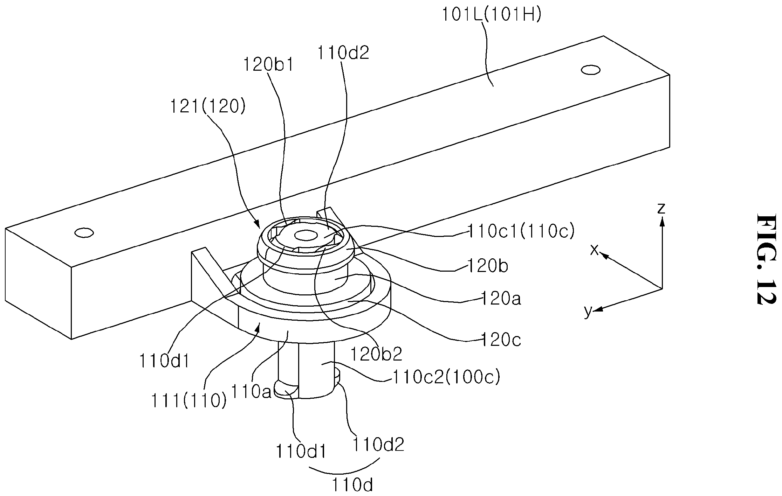

Referring to FIGs. 11 and 12, the coupling part 110 may be formed on one side 101L of the speaker box 101H. The coupling part 110 may include a base 110a, a bridge 110b, and protrusions 110c.

The base 110a may have an overall ring shape. The bridge 110b may traverse the base 110a, and may be coupled to the inner circumferential surface of the base 110a. A plurality of holes 110b1 and 110b2 may be formed to penetrate the base 110a. The first hole 110b1 may be opposite the second hole 110b2 with respect to the bridge 110b.

The protrusions 110c may protrude from the center of the bridge 110b in a direction crossing the bridge 110b. The protrusions 110c may be extend in the forward and rearward directions. The protrusions 110c may be referred to as bosses 110c. A first protrusion 110c1 may protrude forward from the bridge 110b, and a second protrusion 110c2 may protrude rearward from the bridge 110b. The first and second protrusions 110c1 and 110c2 may be located on a straight line, and may have the same shape.

Stoppers 110d may protrude from the ends of the protrusions 110c in a direction crossing the stoppers 110d. The stoppers 110d may be formed at the ends of the first and second protrusions 110c1 and 110c2. Respective stoppers 110d1 and 110d2 may be spaced apart from each other in the circumferential direction of the protrusions 110c. The stoppers 110d may be referred to as hooks 110d.

The holder 120 may include a body 120c, a neck 120a, and a head 120b. The holder 120 may have elasticity. The holder 120 may include a soft material, such as rubber, a cylinder, or the like. Accordingly, transmission of vibration of the speaker 100, coupled to the frame 60, to the frame 60 may be suppressed by the holder 120.

The body 120c may have a ring shape. The diameter of the body 120c may be smaller than the diameter of the base 110a. A plurality of legs 120c1 and 120c2 may protrude from one surface of the body 120c facing the base 110a toward the plurality of holes 110b1 and 110b2. A first leg 120c1 may be aligned with a first hole 110b1, and may have a shape corresponding to the first hole 110b1. A second leg 120c2 may be aligned with a second hole 110b2, and may have a shape corresponding to the second hole 110b2.

The neck 120a may protrude from the other surface of the body 120c in the length direction of the body 120c. The diameter of the neck 120a may be smaller than the diameter of the body 120c. That is, a step may be formed between the neck 120a and the body 120c.

The head 120b may be opposite the body 120c with respect to the neck 120a. The head 120b may protrude from one end of the neck 120a in the radial direction of the neck 120a, and may extend in the circumferential direction of the neck 120a. The diameter of the head 120b may be greater than the diameter of the neck 120a. That is, a step may be formed between the head 120b and the neck 120a.

A first holder 121 may be aligned with the first protrusion 110c1, and may be seated on the base 110a. The first protrusion 110c1 may penetrate the body 120c, the neck 120a, and the head 120b of the first holder 121, and a portion of the body 120c between the first and second legs 120c1 and 120c2 may be caught on the bridge 110b. The first and second legs 120c1 and 120c2 may be inserted into the first and second holes 110b1 and 110b2. The first protrusion 110c1 may be press-fitted into the first holder 121. The first and second stoppers 110d1 and 110d2 may be caught by the end of the neck 120a inside the head 120b. First and second projections 120b1 and 120b2 may protrude from the inner circumferential surface of the head 120b toward the first protrusion 110c1, and may be adjacent to the outer circumferential surface of the first protrusion 110c1 . The first and second projections 120b1 and 120b2 may be disposed alternately with the first and second stoppers 110d1 and 110d2.

Accordingly, the first holder 121 may be detachably coupled to the first protrusion 1 10c1. The first holder 121 may be caught by the bridge 110b and the stoppers 110d1 and 110d2 to be fixed to the coupling part 110.

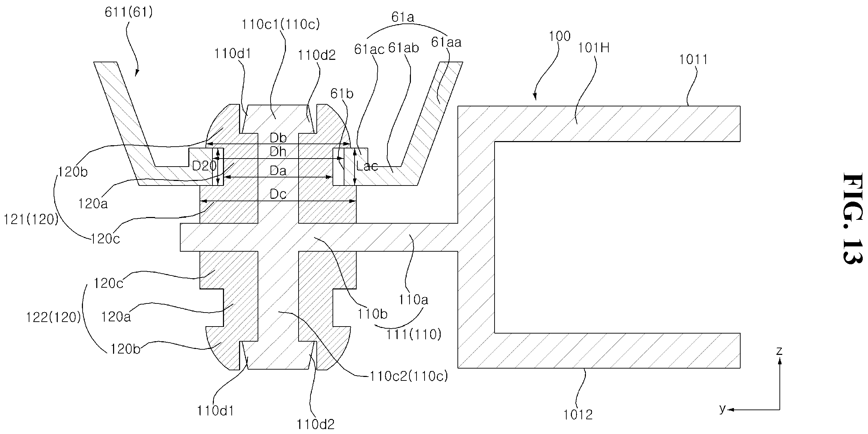

Referring to FIG. 13 together with FIGs. 9 and 10, the plurality of holders 121, 122, 123, and 124 may have the same shape. The coupling structure between the first holder 121 and the first protrusion 110c1 described above with reference to FIGs. 11 and 12 may be identically applied as coupling structures between the remaining holders 122, 123, and 124 and the remaining protrusions 110c2, 110c3, and 110c4.

The coupling parts 110 may include a plurality of coupling parts 111 and 112. Each of the plurality of coupling parts 111 and 112 may include the above-described base 110a, bridge 110b, protrusions 110c, and stoppers 110d.

The first coupling part 111 may be formed on one side of the speaker box 101H. The first coupling part 111 may be located on or adjacent to one side 101HR of the speaker box 101H. The first holder 121 may be detachably coupled to the first protrusion 110c1 of the first coupling part 111. The second holder 122 may be detachably coupled to the second protrusion 110c2 of the first coupling part 111. The first and second holders 121 and 122 may be symmetrical to each other with respect to the base 110a of the first coupling part 111. The first and second holders 121 and 122 may be disposed before and after the base 110a.

A second coupling part 112 may be formed on the other side of the speaker box 101H. The second coupling part 112 may be located on or adjacent to another side 101HL of the speaker box 101H. A third holder 123 may be detachably coupled to the first protrusion 110c1 of the second coupling part 112. A fourth holder 124 may be detachably coupled to the second protrusion 110c2 of the second coupling part 112. The third and fourth holders 123 and 124 may be symmetrical to each other with respect to the base 110a of the second coupling part 112. The third and fourth holders 123 and 124 may be disposed before and after the base 110a.

The first and third holders 121 and 123 may be located on a first surface 1011 of the speaker box 101H. The first surface 1011 may be the front surface of the speaker box 101H. A first groove 101H1 may be formed by depressing the first surface 1011 toward the base 110a of the first coupling part 111. The first holder 121 may be located in the first groove 101H1, and the first groove 101H1 may be formed along the side surface of the first holder 121. A third groove 101H3 may be formed by depressing the first surface 1011 toward the base 110a of the second coupling part 112. The third holder 123 may be located in the third groove 101H3, and the third groove 101H3 may be formed along the side surface of the third holder 123.

The second and fourth holders 122 and 124 may be located on a second surface 1012 of the speaker box 101H. The second surface 1012 may be the rear surface of the speaker box 101H. A second groove 101H2 may be formed by depressing the second surface 1012 toward the base 110a of the first coupling part 111. The second holder 122 may be located in the second groove 101H2, and the second groove 101H2 may be formed along the side surface of the second holder 122. A fourth groove 101H4 may be formed by depressing the second surface 1012 toward the base 110a of the second coupling part 112. The fourth holder 124 may be located in the fourth groove 101H4, and the fourth groove 101H4 may be formed along the side surface of the fourth holder 124.

Accordingly, the holders 121, 122, 123, and 124 may be mounted on the front and rear surfaces of the speaker box 101H. The holders 120 may be coupled to the fixing parts 61 of the frame 60. A distance between these holders 121, 122, 123, and 124 may be constant regardless of the size of the speaker box 101H. That is, the holders 121, 122, 123, ad 124 may be fixed to specific positions of speaker boxes 101H of various sizes, and correspondingly, the fixing parts 61 of the frame 60 may be constant. That is to say, speaker boxes 101H of various sizes may be mounted on the fixing parts 61 formed at specific positions of the frame 60, and thereby, the fixing parts 61 may be applied in common to the speaker boxes 101H of various sizes.

The fixing part 61 may include a fixing body 61a and the fixing hole 61b. the fixing part 61 may have an overall truncated conical shape. The fixing body 61a may include an inclined portion 61aa, a horizontal portion 61ab, and a vertical portion 61ac. The inclined portion 61aa may protrude rearward from the rear surface of the frame 60, and the diameter of the inclined portion 61aa may become smaller as the inclined portion 61aa is away from the rear surface. The horizontal portion 61ab may be bent from the end of the inclined portion 61aa to the inside of the inclined portion 61aa, and may have a ring shape parallel to the rear surface of the frame 60. The vertical portion 61ac may be bent from the end of the horizontal portion 61ab to the rear surface of the frame 60. The horizontal portion 61ab and the vertical portion 61ac may define the boundary of the fixing hole 61b.

A diameter Da of the neck 120a of the holder 120 may be equal to or smaller than a diameter Dh of the fixing hole 61b. A diameter Db of the head 120b of the holder may be greater than the diameter Dh of the fixing hole 61b. A diameter Dc of the body 120c of the holder 120 may be greater than the diameter Dh of the fixing hole 61b. A distance D20 between the body 120c and the head 120b as the length of the neck 120a may be equal to or greater than a length Lac of the vertical portion 61ac. When the neck 120a and the head 120b are inserted into the fixing part 61 through the fixing hole 61b, the neck 120a may be located in the fixing hole 61b, the body 120c may be caught by the horizontal portion 61ab, and the head 120b may be caught by the vertical portion 61ac. That is, the holder 120 may be detachably coupled to the fixing part 61.

As an example, the first surface 1011 of the speaker box 101H may face the rear surface of the frame 60 (see FIG. 8). In this case, the first holder 121 may be coupled to a first fixing part 611, and the third holder 123 may be coupled to a second fixing part 612. Thereby, the speaker 100 may be mounted on the frame.

As another example, the second surface 1012 of the speaker box 101H may face the rear surface of the frame 60 (see FIG. 8). In this case, the second holder 122 may be coupled to the second fixing part 612, and the fourth holder 124 may be coupled to the first fixing part 611. Thereby, the speaker 100 may be mounted on the frame.

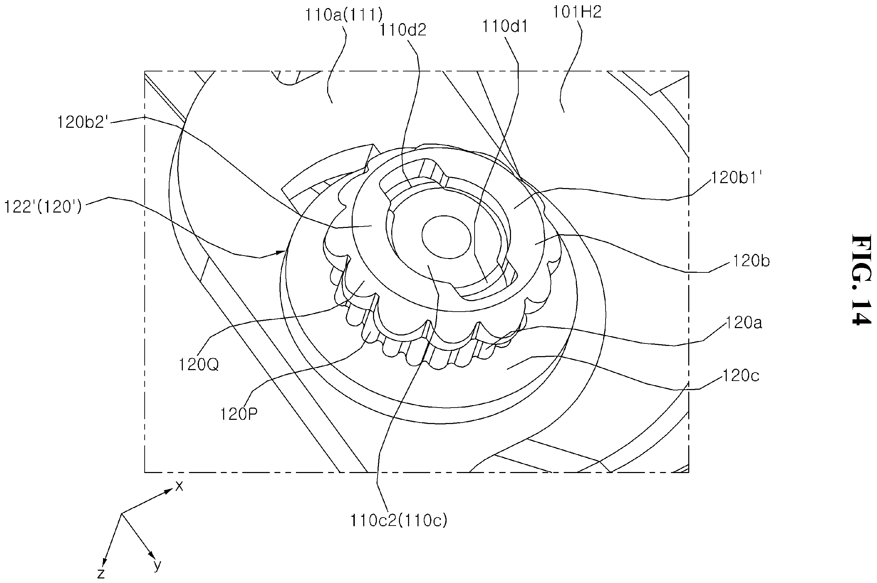

Referring to FIG. 14, unlike the above-described holder 120, first and second projections 120b1' and 120b2' of a holder 120' may be formed in an arc shape along the outer circumferential surface of the protrusion 110c, and may be adjacent to the outer circumferential surface of the protrusion 110c. In addition, serration-shaped projections 120P may be formed on the side surface of the neck 120a, and thereby, the neck 120a of the holder 120' may be in close contact with the vertical portion 61ac (see FIG. 13). Further, serration-shaped projections 120Q may be formed on the side surface of the head 120b, and thereby, the head 120b of the holder 120' may smoothly pass through the fixing hole 61b (see FIG. 13).

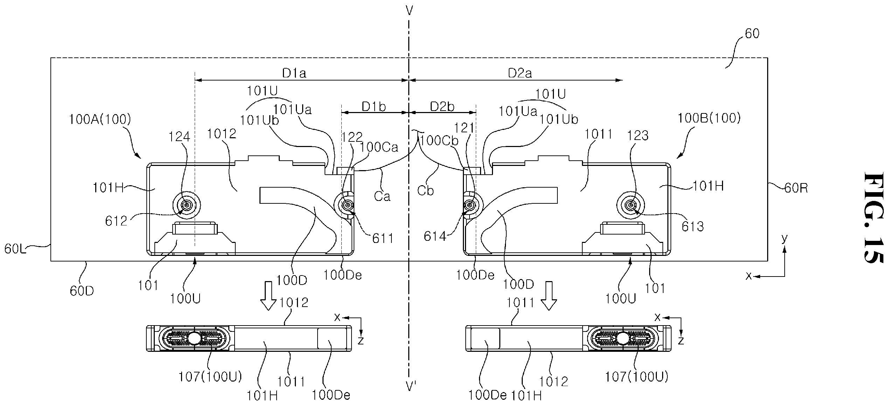

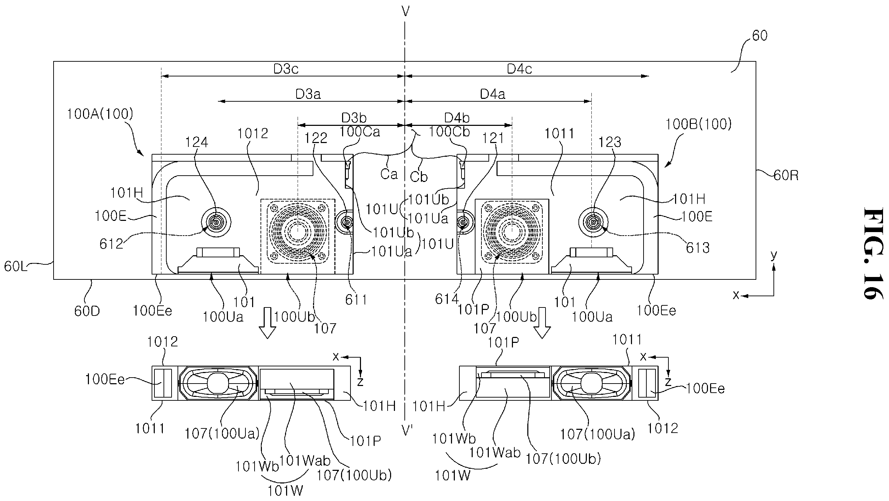

Referring to FIGs. 15 and 16, the speakers 100 may be located behind the frame 60.

The first speaker 100A may be adjacent to the lower side 60D and the left side 60L of the frame 60. The first surface 1011 of the first speaker 100A may face the rear surface of the frame 60, and the second surface 1012 of the first speaker 100A may form the rear surface of the first speaker 100A.

The second speaker 100B may be adjacent to the lower side 60D and the right side 60R of the frame 60. The second surface 1012 of the second speaker 100B may face the rear surface of the frame 60, and the first surface 1011 of the second speaker 100B may form the rear surface of the second speaker 100B.

The first and second speakers 100A and 100B may be inverted (or rotated or flipped) 180 degrees from each other with respect to a straight line V-V' between the first and second speakers 100A and 100B. For example, the straight line V-V' may be parallel to a vertical line passing through the center of the frame 60.

The first holder 121 of the first speaker 100A may be coupled to the first fixing part 611 (see FIG. 8), and the third holder 123 of the first speaker 100A may be coupled to the second fixing part 612 (see in FIG. 8). At this time, the second holder 122 and the fourth holder 124 may be coupled to or separated from the first speaker 100A.

The second holder 122 of the second speaker 100B may be coupled to a fourth fixing part 614, and the fourth holder 124 of the second speaker 100B may be coupled to a third fixing part 613. At this time, the first holder 121 and the third holder 123 may be coupled to or separated from the second speaker 100B. Here, the third and fourth fixing parts 613 and 614 may have the same shape as the first and second fixing parts 611 and 612 (see FIG. 8), and may be adjacent to the right side 60R of the frame 60. A distance between the third and fourth fixing parts 613 and 614 may be the same as a distance between the first and second fixing parts 611 and 612.

Accordingly, the first and second speakers 100A and 100B may be mounted on the frame 60, and the first and second speakers 100A and 100B may be the same type of speakers having different arrangement relationships with respect to the frame 60.

A groove 101U may be formed on the upper side of the speaker box 101H. The groove 101U may include a horizontal surface 101Ua and a vertical surface 101Ub. A cable connector 100C may be mounted in the groove 101U. The groove 101U of the first speaker 100A may be formed on the right side of the speaker box 101H. The groove 101U of the second speaker 100B provided in the shape of the first speaker 100A inverted 180 degrees may be formed on the left side of the speaker box 101H.

A first cable connector 100Ca may be mounted on the horizontal surface 101Ua (see FIG. 15) or the vertical surface 101Ub (see FIG. 16) of the groove 101U of the first speaker 100A. One end of a first cable Ca may be coupled to the first cable connector 100Ca on the right (see FIG. 15) or above (see FIG. 16) of the first cable connector 100Ca, and the first cable Ca may be electrically connected to the first speaker 100A through the first cable connector 100Ca. The other end of the first cable Ca may be electrically connected to the amplifier. The amplifier may be provided on the main board P3 (see FIG. 5).

A second cable connector 100Cb may be mounted on the horizontal surface 101Ua (see FIG. 15) or the vertical surface 101Ub (see FIG. 16) of the groove 101U of the second speaker 100B. One end of a second cable Cb may be coupled to the second cable connector 100Cb on the left (see FIG. 15) or above (see FIG. 16) of the second cable connector 100Cb, and the second cable Cb may be electrically connected to the second speaker 100B through the second cable connector 100Cb. The other end of the second cable Cb may be electrically connected to the amplifier. The amplifier may be provided on the main board P3 (see FIG. 5).

That is, the first cable connector 100Ca and the second cable connector 100Cb may be aligned with each other in the leftward and rightward directions, and may face the same or opposite directions.

Accordingly, the length of the first and second cables Ca and Cb may be minimized, and the need for cable holders for organizing the first and second cables Ca and Cb may be reduced.

Referring to FIG. 15, for example, the speaker unit 100U may be mounted on the lower side of the speaker box 101H, and the diaphragm 107 of the speaker unit 100U may output sound downward. For example, the speaker unit 100U may be a full range speaker unit. Air within the speaker unit 101H may vibrate in response to operation of the speaker unit 100U. A duct 100D may be installed in the speaker box 101H, and may provide a flow path through the air within the speaker box 101H passes. An outlet 100De of the duct 100D may be formed at the lower side of the speaker box 101H, and may be spaced apart from the speaker unit 100U. The duct 100D may provide a low-frequency sound downward. That is, the sound from the duct 100D, which has weak sound directivity, may be less influenced by arrangement of the duct 100D. The speaker unit 100U, which outputs a relatively high-frequency sound, may be located relatively outside compared to the duct 100D.

A distance D1a between the speaker unit 100U of the first speaker 100A and the straight line V-V' may be greater than a distance D1b between the outlet 100De of the duct 100D of the first speaker 100A and the straight line V-V'. A distance D2a between the speaker unit 100U of the second speaker 100B and the straight line V-V' may be greater than a distance D2b between the outlet 100De of the duct 100D of the second speaker 100B and the straight line V-V'. For example, the distances D1a and D2a may be equal to each other and the distances D1b and D2b may also be equal to each other, and in this case, sounds provided by the first and second speakers 100A and 100B may be symmetrical. Further, as the speaker units 100U of the first and second speakers 100A and 100B are disposed relatively far apart, the sense of stereo separation of sounds may be improved.

Referring to FIG. 16, for example, a first speaker unit 100Ua may be mounted on the lower side of the speaker box 101H, and the diaphragm 107 of the first speaker unit 100Ua may provide sound downward. For example, the first speaker unit 100Ua may be a full range speaker unit. A second speaker unit 100Ub may be mounted in the speaker box 101H, and may provide sound forward (or rearward). For example, the second speaker unit 100Ub may be a woofer. Air within the speaker unit 101H may vibrate in response to operation of the first speaker unit 100Ua and/or the second speaker unit 100Ub. A duct 100E may be installed in the speaker box 101H, and may provide a flow path through the air within the speaker box 101H passes. An outlet 100Ee of the duct 100E may be formed at the lower side of the speaker box 101H, and may be opposite an outlet 100Ue of the second speaker unit 100Ub with respect to the first speaker unit 100Ua. The duct 100E may provide a low-frequency sound downward. That is, the sounds from the duct 100E, which has weak sound directivity, and the second speaker unit 100Ub may be less influenced by arrangement of the duct 100E and the second speaker unit 100Ub. The first speaker unit 100Ua, which outputs a relatively high-frequency sound, may be located relatively outside compared to the second speaker unit 100Ub.

A distance D3c between the outlet 100Ee of the duct 100E of the first speaker 100A and the straight line V-V' may be greater than a distance D3a between the first speaker unit 100Ua of the first speaker 100A and the straight line V-V'. The distance D3a may be greater than a distance D3b between the outlet 100Ue of the second speaker unit 100Ub and the straight line V-V'. A distance D4c between the outlet 100Ee of the duct 100E of the second speaker 100B and the straight line V-V' may be greater than a distance D4a between the first speaker unit 100Ua of the second speaker 100B and the straight line V-V'. The distance D4a may be greater than a distance D4b between the outlet 100Ue of the second speaker unit 100Ub of the second speaker 100B and the straight line V-V'. For example, the distances D3a and D4a may be equal to each other, the distances D3b and D4b may also be equal to each other, and the distances D3c and D4c may also be equal to each other. As the first speaker units 100Ua of the first and second speakers 100A and 100B are disposed relatively far apart, the sense of stereo separation of sounds may be improved.

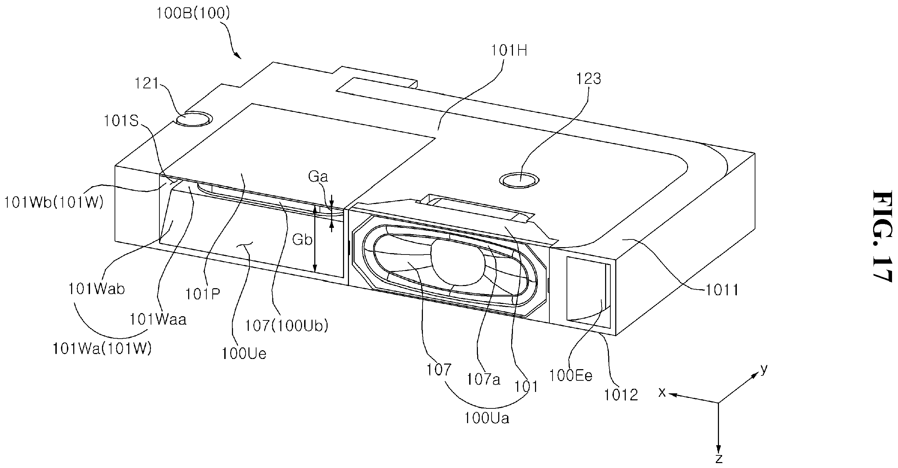

Referring to FIGs. 16 and 17, the diaphragm 107 of the second speaker unit 100Ub, which vibrates back and forth, may be disposed closer to the first surface 1011 than the second surface 1012 of the speaker box 101H. That is, the second speaker unit 100Ub of the first speaker 100A may be disposed closer to the front surface than the rear surface of the speaker box 101H, and the second speaker unit 100Ub of the second speaker 100B may be disposed closer to the rear surface than the front surface of the speaker box 101H.

A guide plate 101P may cover the diaphragm 107 of the second speaker unit 100Ub while being spaced apart from the diaphragm 107. The guide plate 101P may form a portion of the first surface 1011 of the speaker box 101H. The guide plate 101P may be a plate formed of a metal, such as iron (Fe). A space 101S between the diaphragm 107 and the guide plate 101P may be opened downward. Partition walls 101W may include a mount wall 101Wa equipped with the diaphragm 107 mounted thereon and facing the guide plate 101P, and a side wall 101Wb forming the boundary of the space 101S between the mount wall 101Wa and the guide plate 101P.

The mount wall 101Wa may include a first part 101Waa and a second part 101Wab. The first part 101Waa is a portion of the mount wall 101Wa on which the diaphragm 107 is mounted, and may be disposed parallel to the guide plate 101P. The second part 101Wab may extend from the lower side of the first part 101Waa toward the second surface 1012 of the speaker box 101H to be inclined. A gap Gb between the second part 101Wab and the guide plate 101P may be greater than a gap Ga between the first part 101Waa and the guide plate 101P, and may increase as the second part 101Wab becomes closer to the lower side of the speaker box 101H. An outlet of the space 101S, i.e., the outlet 101Ue of the second speaker unit 100Ub, may be formed between the lower side of the guide plate 101P and the lower side of the second part 101Wab.

Accordingly, the guide plate 101P and the partition walls 101W may guide sound from the diaphragm 107 of the second speaker unit 100Ub downward.

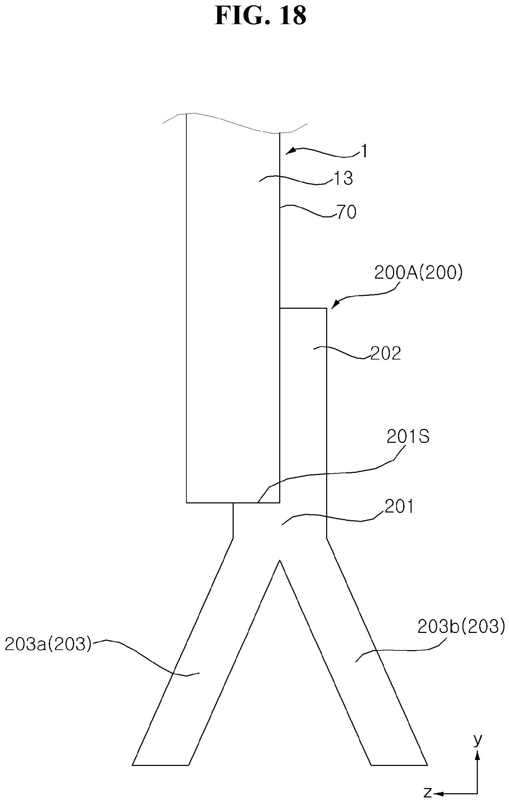

Referring to FIGs. 18 and 1, a stand 200 of the display device 1 may be coupled to the lower side of the side frame 13, and may support the remaining components of the display device 1. One stand 200 or two or more stands 200 may be provided. Stands 200A and 200B may be spaced apart from each other along the lower side, i.e., the second long side LS2, of the side frame 13. A first stand 200A may be adjacent to the left side, i.e., the first short side SS1, of the side frame 13, and a second stand 200B may be adjacent to the right side, i.e., the second short side SS2, of the side frame 13.

The stand 200 may include a support 201, a coupling part 202, and legs 203. The support 201 may be located under the lower side of the side frame 13. The coupling part 202 may extend upward from the support 201, and may be coupled to the rear surface of the back cover 70. The legs 203 may extend downward from the support 201 to be inclined, and may be separated from each other by a certain angle. A first leg 203a may extend forward from the support 201 to be inclined, and a second leg 203b may extend rearward from the support 201 to be inclined. Accordingly, the stand 200 coupled to the back cover 70 may be placed on the ground to support the components of the display deice 1 excluding the stand 200.

The lower side of the side frame 13 may be located on or adjacent to the upper surface, i.e., a support surface 201S, of the support 201. The width of the support surface 201S in the forward and rearward directions may be smaller than the width of the lower side of the side frame 130. That is, the support surface 201S may cover a portion of the lower side of the side frame 13.

Sound output from the first speaker 100A (see FIG. 16) may be provided to the outside through a first hole 13Ha (see FIG. 7). The first hole 13Ha may include a first outer hole 13Haa facing the diaphragm 107 of the first speaker unit 100Ua (see FIG. 16), and a first inner hole 13Hab facing the outlet 100Ue of the second speaker unit 100Ub (see FIGs. 16 and 17).

Sound output from the second speaker 100B (see FIG. 16) may be provided to the outside through a second hole 13Hb (see FIG. 7). The second hole 13Hb may include a second outer hole 13Hba facing the diaphragm 107 of the first speaker unit 100Ua (see FIG. 16), and a second inner hole 13Hbb facing the outlet 100Ue of the second speaker unit 100Ub (see FIGs. 16 and 17).

The support surface 201S of the first stand 200A may cover some of the first inner hole 13Hab. The first inner hole 13Hab may include a closed hole 13H1, which are covered by the support surface 201S, and an open hole 13H2, which are not covered by the support surface 201S. A space (with reference to the gap Ga in FIG. 17) between the first part 101Waa of the mount wall 101Wa and the guide plate 101P may face the open hole 13H2. The outlet 200Ue of the second speaker unit 100Ub (in FIGs. 16 and 17) may face not only the open hole 13H2 but also the closed hole 13H1.

Accordingly, the second speaker unit 100Ub of the first speaker 100A may provide sound to the outside through the first inner hole 13Hab.

The support surface 201S of the second stand 200B may cover some of the second inner hole 13Hbb. The second inner hole 13Hbb may include a closed hole 13H1, which are covered by the support surface 201S, and an open hole 13H2, which are not covered by the support surface 201S. A space (with reference to the gap Ga in FIG. 17) between the first part 101Waa of the mount wall 101Wa and the guide plate 101P may face the closed hole 13H1 and the support surface 201S. A portion of the outlet 200Ue (in FIGs. 16 and 17) of the second speaker unit 100Ub may face the closed hole 13H1 and the support surface 201S, and the remaining portion may face the open hole 13H2.

Accordingly, the second speaker unit 100Ub of the second speaker 100B provided in the shape of the first speaker 100A inverted 180 degrees with respect to the straight line V-V', may provide sound to the outside through the second inner hole 13Hbb.

The second speaker units 100Ub may be woofers, and may output sound of a low-frequency range (Hz). In this case, there may be little difference in characteristics between the sound from the second speaker unit 100Ub of the first speaker 100A, which is output through the first inner hole 13Hab, and the sound from the second speaker unit 100Ub of the second speaker 100B, which is output through the second inner hole 13Hbb.

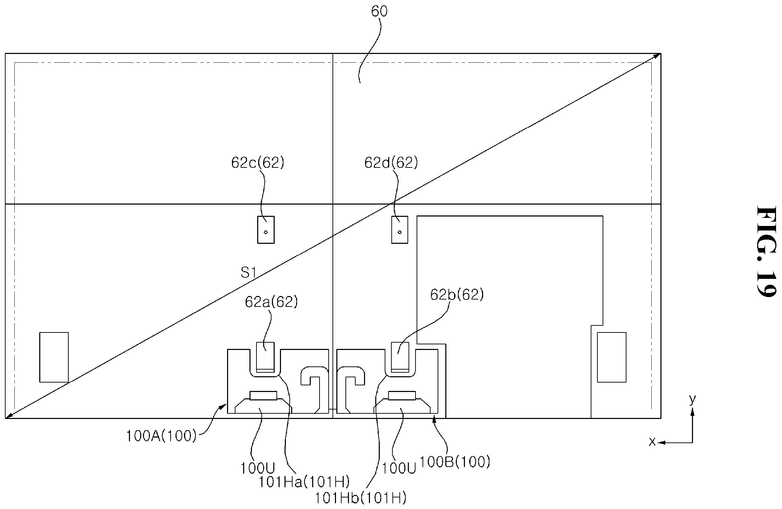

Referring to FIGs. 19 to 21, back cover fixing parts 62 may be formed on the rear surface of the frame 60. First to fourth back cover fixing parts 62a, 62b, 62c, and 62d may be located at the vertices of a square. The back cover 70 (see FIGs. 2 and 3) may be coupled to the back cover fixing parts 62. Video electronics standards association (VESA) holes may be formed in the back cover fixing parts 62.

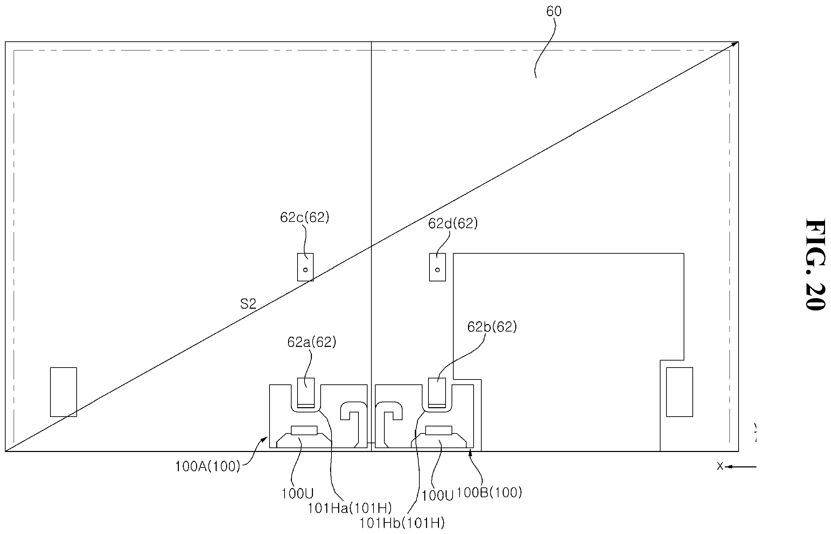

Referring FIGs. 19 and 20, the frame 60 may have a first diagonal length S1 or a second diagonal length S2. The second diagonal length S2 may be greater than the first diagonal length S1. A first hole 101Ha may be formed in the speaker box 101H of the first speaker 100A, and the first back cover fixing part 62a may be located in the first hole 101Ha. A second hole 101Hb may be formed in the speaker box 101H of the second speaker 100B, and the second back cover fixing part 62b may be located in the second hole 101Hb.

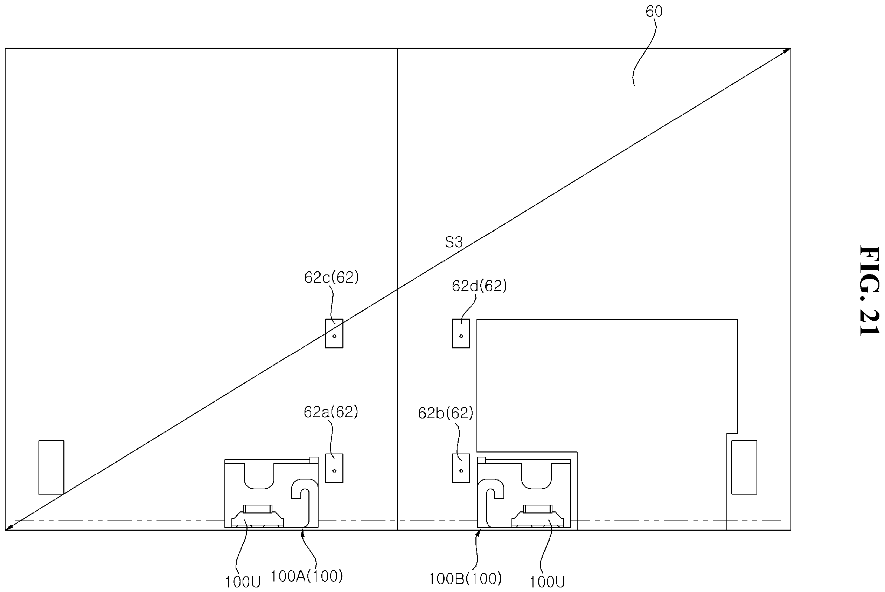

Referring to FIG. 21, the frame 60 may have a third diagonal length S3. The third diagonal length S3 may be greater than the second diagonal length S2. The speaker box 101H of the first speaker 100A may be located on the left of the first back cover fixing part 62a. The speaker box 101H of the second speaker 100B may be located on the right of the second back cover fixing part 62b.

Accordingly, the first and second speakers 100A and 100B may be mounted on the rear surface of the frame 60 while avoiding the back cover fixing parts 62.

Referring to FIGs. 1 to 21, a sound device may include a frame, a first speaker adjacent to the frame, a second speaker spaced apart from the first speaker, a first holder located between the frame and the first speaker and coupled to the frame and the first speaker, and a second holder located between the frame and the second speaker and coupled to the frame and the second speaker, and the second speaker may have the same shape as the first speaker inverted 180 degrees.

The first speaker may include a speaker box and a speaker unit coupled to the speaker box, and the speaker box may include a first part which faces the frame and to which the first holder is coupled, and a second part which is opposite to the first part to which the second holder is coupled.

The first holder and the second holder may be detachably coupled to the first part and the second part, respectively.

The speaker box may further include a base formed at one side of the speaker box, a first protrusion protruding from the base toward the frame, and a second protrusion protruding from the base in an opposite direction to the first protrusion, the first holder may be coupled to the first protrusion, and the second holder may be coupled to the second protrusion.

The first protrusion and the second protrusion may be symmetrical to each other with respect to the base, and the first holder and the second holder may be symmetrical to each other with respect to the base.

The speaker box may further include a pair of hooks protruding from the speaker box and spaced apart from each other, the pair of hooks may be eccentric from a center of the speaker box or disposed alternately, and one of the pair of hooks may be coupled to the frame.

The second speaker may be spaced apart from the first speaker in one direction, and may be rotated 180 degrees from the first speaker with respect to a straight line between the first speaker and the second speaker orthogonal to the one direction.

Each of the first speaker and the second speaker may include a speaker box and a speaker unit coupled to the speaker box, and a distance between the speaker unit of the first speaker and the straight line may be equal to a distance between the speaker unit of the second speaker and the straight line.

The speaker unit may include a first speaker unit spaced apart from the straight line by a first distance, and a second speaker unit spaced apart from the straight line by a second distance, the first speaker unit may output sound of a relatively higher-frequency range than the second speaker unit, and the first distance may be greater than the second distance.

The first speaker unit may be a full range speaker unit, and the second speaker unit may be a woofer.

The sound device may further include an amplifier, a first cable electrically connected to the amplifier, a second cable electrically connected to the amplifier, a first cable connector electrically connecting the first cable to the first speaker, and a second cable connector electrically connecting the second cable to the second speaker, and the first cable connector and the second cable connector may be aligned with each other in a direction in which the first speaker and the second speaker are spaced apart from each other, and may face the same direction or different directions.

A display device may include the sound device and a display panel coupled to the frame of the sound device.

The display device may further include a side frame extending along an edge of the frame and coupled to the frame, and a first stand and a second stand coupled to a lower side of the side frame and spaced apart from each other along the lower side, the first speaker and the second speaker may be spaced apart from each other along the lower side of the side frame, and the side frame may include a first hole formed at the lower side of the side frame and through which sound of the first speaker passes, and a second hole formed at the lower side of the side frame and through which sound of the second speaker passes.

The second hole may include a second outer hole and a second inner hole located between the second outer hole and the first hole, the second speaker may include a speaker box, a first speaker unit coupled to the speaker box and outputting sound toward the second outer hole, and a second speaker unit coupled to the speaker box and outputting sound toward the second inner hole, the second inner hole may include a closed hole covered by the second stand and an open hole not covered by the second stand, and an outlet of the second speaker unit may face the closed hole and the open hole.

The first speaker and the second speaker may be coupled to a rear of the frame, the second speaker unit may include a diaphragm adjacent to a rear side of the speaker box and vibrating back and forth, a guide plate covering a rear of the diaphragm, and a partition wall forming a boundary of a space between the diaphragm and the guide plate, together with the guide plate, and the partition wall may include a first part to which the diaphragm is coupled and a second part extending obliquely from the first part toward a front surface of the speaker box.

The effects of a sound device and a display device including the same according to the present disclosure will be described as follows.

According to at least one of the embodiments of the present disclosure, a structure which couples a speaker to a frame may be provided.

According to at least one of the embodiments of the present disclosure, a structure which couples a first speaker and a second speaker provided in the shape of the inverted first speaker to a frame may be provided.

According to at least one of the embodiments of the present disclosure, a structure for implementing symmetry between sound from a first speaker and sound from a second speaker may be provided.

According to at least one of the embodiments of the present disclosure, a structure which improves the sense of stereo separation between a first speaker and a second speaker may be provided.

According to at least one of the embodiments of the present disclosure, a structure which minimizes the length of cables connecting a first speaker and a second speaker to an amplifier may be provided.

According to at least one of the embodiments of the present disclosure, a structure which expands an outlet of a speaker unit with respect to a stand of a display device which covers a speaker hole may be provided.

An additional scope of applicability of the present disclosure will become apparent from the above detailed description. However, since various changes and modifications within the spirit and scope of the present disclosure may be clearly understood by those skilled in the art, the detailed description and specific embodiments such as the exemplary embodiments of the present disclosure should be understood as being given only as examples.

Any embodiments or other embodiments of the present disclosure described above are not exclusive or distinct from each other. Configurations or functions of any embodiments or other embodiments of the present disclosure described above may be used in combination or combined.

For example, this means that a component A described in a particular embodiment and/or drawing may be combined with a component B described in another embodiment and/or drawing. That is, even if combination between components is not directly described, it means that the combination is possible, except in cases in which it is described that the combination is impossible.

The above detailed description should not be construed as being restrictive in any respect and should be considered as being illustrative. The scope of the present disclosure should be determined by reasonable interpretation of the accompanying claims, and all changes within the equivalent scope of the present disclosure are included in the scope of the present disclosure.

## Claims

1. A sound device comprising:
a frame (60);
a first speaker (100A) adjacent to the frame (60);
a second speaker (100B) spaced apart from the first speaker (100A);
a first holder (121) located between the frame (60) and the first speaker (100A) and coupled to the frame (60) and the first speaker (100A); and
a second holder (122) located between the frame (60) and the second speaker (100B) and coupled to the frame (60) and the second speaker (100B),
wherein the second speaker (100B) has the same shape as the first speaker (100A) inverted 180 degrees.

2. The sound device of claim 1, wherein the first speaker (100A) comprises:
a speaker box (101H); and
a speaker unit (100U) coupled to the speaker box (101H),
wherein the speaker box (101H) comprises:
a first part which faces the frame (60) and to which the first holder (121) is coupled; and
a second part which is opposite to the first part to which the second holder (122) is coupled.

3. The sound device of claim 2, wherein the first holder (121) and the second holder (122) are detachably coupled to the first part and the second part, respectively.

4. The sound device of claim 2 or 3, wherein the speaker box (101H) further comprises:
a base (110a) formed at one side of the speaker box (101H);
a first protrusion (110c1) protruding from the base (110a) toward the frame (60); and
a second protrusion (110c2) protruding from the base (110a) in an opposite direction to the first protrusion (110c1), wherein:
the first holder (121) is coupled to the first protrusion (110c1); and
the second holder (122) is coupled to the second protrusion (110c2).

5. The sound device of claim 4, wherein:
the first protrusion (110c1) and the second protrusion (110c2) are symmetrical to each other with respect to the base (110a); and
the first holder (121) and the second holder (122) are symmetrical to each other with respect to the base (1 10a).

6. The sound device of any one of claims 2 to 5, wherein the speaker box (101H) further comprises a pair of hooks (101Ka, 101Kb) protruding from the speaker box (101H) and spaced apart from each other,
wherein the pair of hooks (101Ka, 101Kb) is eccentric from a center of the speaker box (101H) or disposed alternately, and one of the pair of hooks (101Ka, 101Kb) is coupled to the frame (60).

7. The sound device of any one of claims 1 to 6, wherein the second speaker (100B) is spaced apart from the first speaker (100A) in one direction, and is rotated 180 degrees from the first speaker (100A) with respect to a straight line between the first speaker (100A) and the second speaker (100B) orthogonal to the one direction.

8. The sound device of claim 7, wherein each of the first speaker (100A) and the second speaker (100B) comprises:
a speaker box (101H); and
a speaker unit (100U) coupled to the speaker box (101H),
wherein a distance between the speaker unit (100U) of the first speaker (100A) and the straight line is equal to a distance between the speaker unit (100U) of the second speaker (100B) and the straight line.

9. The sound device of claim 7 or 8, wherein the speaker unit (100U) comprises:
a first speaker unit (100Ua) spaced apart from the straight line by a first distance; and
a second speaker unit (100Ub) spaced apart from the straight line by a second distance,
wherein:
the first speaker unit (100Ua) outputs sound of a relatively higher-frequency range than the second speaker unit (100Ub); and
the first distance is greater than the second distance.

10. The sound device of claim 9, wherein:
the first speaker unit (100Ua) is a full range speaker unit; and
the second speaker unit (100Ub) is a woofer.

11. The sound device of any one of claims 1 to 10, further comprising:
an amplifier;
a first cable (Ca) electrically connected to the amplifier;
a second cable (Cb) electrically connected to the amplifier;
a first cable connector (100Ca) electrically connecting the first cable (Ca) to the first speaker (100A); and
a second cable connector (100Cb) electrically connecting the second cable (Cb) to the second speaker (100B),
wherein the first cable connector (100Ca) and the second cable connector (100Cb) are aligned with each other in a direction in which the first speaker (100A) and the second speaker (100B) are spaced apart from each other, and face the same direction or different directions.

12. A display device (1) comprising:
the sound device of any one of claims 1 to 11; and
a display panel (10) coupled to the frame (60) of the sound device.

13. The display device (1) of claim 12, further comprising:
a side frame (13) extending along an edge of the frame (60) and coupled to the frame (60); and
a first stand (200A) and a second stand (200B) coupled to a lower side of the side frame (13) and spaced apart from each other along the lower side,
wherein:
the first speaker (100A) and the second speaker (100B) are spaced apart from each other along the lower side of the side frame (13); and
the side frame (13) comprises:
a first hole (13Ha) formed at the lower side of the side frame (13) and through which sound of the first speaker (100A) passes; and
a second hole (13Hb) formed at the lower side of the side frame (13) and through which sound of the second speaker (100B) passes.

14. The display device (1) of claim 13, wherein:
the second hole (13Hb) comprise:
a second outer hole (13Hba); and
a second inner hole (13Hbb) located between the second outer hole (13Hba) and the first hole (13Ha);
the second speaker (100B) comprises:
a speaker box (101H);
a first speaker unit (100Ua) coupled to the speaker box (101H) and outputting sound toward the second outer hole (13Hba); and
a second speaker unit (100Ub) coupled to the speaker box (101H) and outputting sound toward the second inner hole (13Hbb);
the second inner hole (13Hbb) comprise:
a closed hole (13H1) covered by the second stand (200B); and
an open hole (13H2) not covered by the second stand (200B); and
an outlet (100Ue) of the second speaker unit (100Ub) faces the closed hole (13H1) and the open hole (13H2).

15. The display device (1) of claim 14, wherein:
the first speaker (100A) and the second speaker (100B) are coupled to a rear of the frame (60);
the second speaker unit (100B) comprises:
a diaphragm (107) adjacent to a rear side of the speaker box (101H) and vibrating back and forth;
a guide plate (101P) covering a rear of the diaphragm (107); and
a partition wall (101W) forming a boundary of a space between the diaphragm (107) and the guide plate (101P), together with the guide plate (101P); and
the partition wall (101W) comprises:
a first part (101Waa) to which the diaphragm (107) is coupled; and
a second part (101Wab) extending obliquely from the first part (101Waa) toward a front surface of the speaker box (101H).
